# EUROPEAN PATENT APPLICATION

(11) **EP 2 521 186 A1**
(43) Date of publication of application: **07.11.2012**
(21) Application number: 10840911.1
(22) Date of filing: 21.12.2010
(51) Int. Cl.: H01L 31/042, H01L 31/0216, C01G 23/053

(54) **METHOD FOR MANUFACTURING A SOLAR CELL**

(30) Priority: 28.12.2009 JP 2009297479
(71) Applicant: Sharp Kabushiki Kaisha, Osaka-shi, Osaka 545-8522 (JP)
(72) Inventor: HASHIMOTO, Takahiro, Osaka-shi, Osaka, 545-8522 (JP)
(74) Representative: Müller-Boré & Partner Patentanwälte
(86) International application number: PCT/JP2010/072960
(87) International publication number: WO 2011/081054

(57) **Abstract**

There is provided a method for manufacturing a solar cell, including the steps of: applying an antireflective-film-forming solution (5a) containing at least one of a metal oxide and a precursor of the metal oxide onto one main surface of a semiconductor substrate (1); and heating the semiconductor substrate (1) having the antireflective-film-forming solution (5a) applied thereon, wherein in the step of applying an antireflective-film-forming solution (5a), the antireflective-film-forming solution (5a) is applied in such an atmosphere that a water content is 0 g/m³ or more and 9.4 g/m³ or less.

## Description

### TECHNICAL FIELD

The present invention relates to a method for manufacturing a solar cell.

### BACKGROUND ART

Expectations for a solar cell that directly converts sunlight energy into electrical energy as the next-generation energy source has rapidly grown in recent years particularly from the standpoint of global environmental problems. Among the various types of solar cells employing a compound semiconductor or an organic material, a solar cell employing silicon crystal as a semiconductor substrate is now the main stream.

In the solar cell, electrons generated in the semiconductor substrate by light entering the semiconductor substrate are separated from a hole by a pn junction to take out a current. In this solar cell, the photoelectric conversion efficiency can be increased by reducing a reflectivity of the light entering the semiconductor substrate. Therefore, an antireflective film is formed on one main surface of the semiconductor substrate.

PTL 1 (Japanese Patent Laying-Open No. 53-146995), for example, discloses a technique of applying, onto a silicon substrate, an application composition fabricated by mixing orthotitanate n-butyl, acetic acid and ethyl alcohol, and heating the application composition in air, thereby forming an antireflective film formed of a titanium oxide thin film on the silicon substrate.

PTL 2 (Japanese Patent Laying-Open No. 54-76629) discloses a technique of applying, onto a silicon substrate, an application composition fabricated by mixing ethyl alcohol, phosphorus pentoxide, isopropyl titanate, and acetic acid, and heating the application composition in air, thereby forming a titanium oxide thin film containing phosphorus as an impurity on the silicon substrate, and then, heating the titanium oxide thin film in the nitrogen atmosphere and diffusing phosphorus from the titanium oxide thin film onto the silicon substrate, thereby forming an antireflective film formed of the titanium oxide thin film on the silicon substrate and forming a pn junction in the silicon substrate.

### CITATION LIST

### PATENT LITERATURE

PTL 1: Japanese Patent Laying-Open No. 53-146995
PTL 2: Japanese Patent Laying-Open No. 54-76629

### SUMMARY OF INVENTION

### TECHNICAL PROBLEM

However, as described in PTL 1 and PTL 2, when the antireflective film is formed on the silicon substrate by applying the solution onto the silicon substrate and heating the solution, the antireflective film formed on the silicon substrate becomes clouded, which leads to impairment of the appearance of the solar cell.

In light of the above circumstances, an object of the present invention is to provide a method for manufacturing a solar cell by which cloudiness of an antireflective film can be reduced and a solar cell having excellent appearance can be manufactured in a stable manner.

### SOLUTION TO PROBLEM

The present invention is directed to a method for manufacturing a solar cell, including the steps of: applying an antireflective-film-forming solution containing at least one of a metal oxide and a precursor of the metal oxide onto one main surface of a semiconductor substrate; and heating the semiconductor substrate having the antireflective-film-forming solution applied thereon, wherein in the step of applying an antireflective-film-forming solution, the antireflective-film-forming solution is applied in such an atmosphere that a water content is 0 g/m³ or more and 9.4 g/m³ or less.

Preferably, in the method for manufacturing a solar cell according to the present invention, the antireflective-film-forming solution contains a dopant for forming a pn junction on the semiconductor substrate.

Preferably, in the method for manufacturing a solar cell according to the present invention, the antireflective-film-forming solution contains a dopant for forming an n-type dopant diffusion layer on the semiconductor substrate.

Preferably, in the method for manufacturing a solar cell according to the present invention, in the step of applying an antireflective-film-forming solution, the antireflective-film-forming solution is applied in such an atmosphere that the atmosphere includes a dry gas.

Preferably, in the method for manufacturing a solar cell according to the present invention, the antireflective-film-forming solution is applied while introducing a dry gas into the atmosphere.

Preferably, in the method for manufacturing a solar cell according to the present invention, the dry gas contains at least one type selected from the group consisting of oxygen, nitrogen, helium, neon, argon, krypton, xenon, and radon.

Preferably, in the method for manufacturing a solar cell according to the present invention, the antireflective-film-forming solution is a solution containing titanium alkoxide.

### ADVANTAGEOUS EFFECTS OF INVENTION

According to the present invention, there can be provided a method for manufacturing a solar cell by which cloudiness of an antireflective film can be reduced and a solar cell having excellent appearance can be manufactured in a stable manner.

### BRIEF DESCRIPTION OF DRAWINGS

Fig. 1 is a schematic cross-sectional view illustrating a part of an exemplary manufacturing process of a method for manufacturing a solar cell according to the present invention.
Fig. 2 is a schematic cross-sectional view illustrating a part of the exemplary manufacturing process of the method for manufacturing a solar cell according to the present invention.
Fig. 3 is a schematic view illustrating one example of a step of applying an antireflective-film-forming solution.
Fig. 4 is a schematic view illustrating one example of the step of applying the antireflective-film-forming solution.
Fig. 5 is a schematic view illustrating one example of the step of applying the antireflective-film-forming solution.
Fig. 6 is a schematic cross-sectional view illustrating a part of the exemplary manufacturing process of the method for manufacturing a solar cell according to the present invention.
Fig. 7 is a schematic cross-sectional view illustrating a part of the exemplary manufacturing process of the method for manufacturing a solar cell according to the present invention.
Fig. 8 is a schematic cross-sectional view of one example of a solar cell manufactured by one example of the method for manufacturing a solar cell according to the present invention.
Fig. 9 is a photograph of a main surface of a p-type polycrystalline silicon substrate immediately after spin application of the antireflective-film-forming solution in Example 1.
Fig. 10 is a photograph of the main surface of the p-type polycrystalline silicon substrate immediately after spin application of the antireflective-film-forming solution in Example 2.
Fig. 11 is a photograph of the main surface of the p-type polycrystalline silicon substrate immediately after spin application of the antireflective-film-forming solution in Example 3.
Fig. 12 is a photograph of the main surface of the p-type polycrystalline silicon substrate immediately after spin application of the antireflective-film-forming solution in Comparative Example 1.
Fig. 13 is a photograph of the main surface of the p-type polycrystalline silicon substrate immediately after spin application of the antireflective-film-forming solution in Comparative Example 2.

### DESCRIPTION OF EMBODIMENTS

Embodiments of the present invention will be described hereinafter. In the drawings of the present invention, the same reference characters indicate the same or corresponding portions.

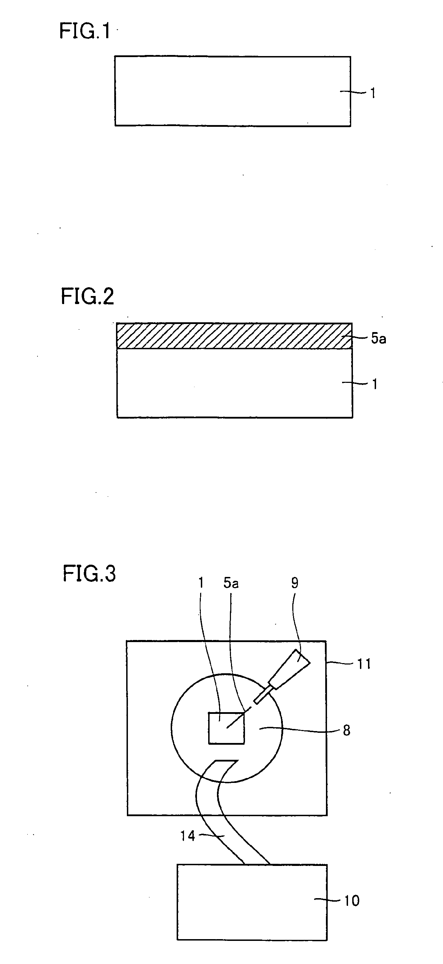

First, as shown in a schematic cross-sectional view in Fig. 1, a p-type silicon substrate 1 made of a p-type silicon crystal is prepared as a semiconductor substrate. P-type silicon substrate 1 can be obtained, for example, by cutting, into silicon blocks, a silicon ingot recrystallized after melting a p-type silicon crystal raw material in a crucible, and then, cutting the silicon block by a wire saw.

A surface of p-type silicon substrate 1 may, for example, be etched with an alkaline solution or acid solution to remove a damaged layer generated at the time of slicing p-type silicon substrate 1. By adjusting the etching conditions during etching, minute protrusions and recesses (not shown) may also be formed on the surface of p-type silicon substrate 1. When these protrusions and recesses are formed on the surface of p-type silicon substrate 1, reflection of light entering p-type silicon substrate 1 is reduced, and thus, the photoelectric conversion efficiency of a solar cell can be increased.

Next, as shown in a schematic cross-sectional view in Fig. 2, an antireflective-film-forming solution 5a is applied onto one main surface (hereinafter referred to as "first main surface"), which is a surface on one side of p-type silicon substrate 1. Antireflective-film-forming solution 5a contains at least one of a metal oxide and a precursor of the metal oxide in a solvent.

Titanium oxide, tin oxide, aluminum oxide, silicon dioxide, silicon oxide, magnesium oxide and the like can, for example, be used as the metal oxide.

A material serving as a precursor of the aforementioned metal oxide such as titanium alkoxide such as titanium tetraisopropoxide (Ti[OCH(CH₃)₂]₄) can, for example, be used as the precursor of the metal oxide.

A solvent containing alcohol such as isopropyl alcohol and ethanol, and the like can, for example, be used as the solvent.

In addition to the above, antireflective-film-forming solution 5a preferably contains a dopant for forming a pn junction on the semiconductor substrate. In this case, application of antireflective-film-forming solution 5a eliminates the need for a step of diffusing the dopant for forming a pn junction on the semiconductor substrate. Therefore, there is a tendency that the solar cell can be manufactured more efficiently. For example, in the present embodiment, antireflective-film-forming solution 5a can include diphosphorus pentoxide and the like containing phosphorus that serves as an n-type dopant. When the semiconductor substrate has an n conductivity type, antireflective-film-forming solution 5a can include a compound and the like containing boron that serves as a p-type dopant.

Fig. 3 shows a schematic view illustrating one example of a step of applying antireflective-film-forming solution 5a. A conventionally known application apparatus such as a spin application apparatus, an inkjet application apparatus or a screen printing apparatus can be used as an apparatus for applying antireflective-film-forming solution 5a. In the present embodiment, however, description will be given to a method for spin-applying antireflective-film-forming solution 5a by means of the spin application apparatus.

First, p-type silicon substrate 1 is placed on a rotating plate 8 placed within an application apparatus 11, such that the first main surface of p-type silicon substrate 1 is directed upward.

Then, antireflective-film-forming solution 5a is applied onto the surface of p-type silicon substrate 1 through an application nozzle 9 while rotating p-type silicon substrate 1 by rotating rotating plate 8. As a result, antireflective-film-forming solution 5a is spin-applied. At this time, a dry gas is introduced from a dry gas supply apparatus 10 through a dry gas introduction pipe 14 into the atmosphere in application apparatus 11 where antireflective-film-forming solution 5a is being spin-applied, and thereby, antireflective-film-forming solution 5a is spin-applied in such an atmosphere that a water content is 0 g/m³ or more and 9.4 g/m³ or less.

The inventor of the present invention has found that in manufacturing the solar cell by using the titanium alkoxide (e.g., Ti[OCH(CH₃)₂]₄) solution, the antireflective film formed from this antireflective-film-forming solution may become clouded and the appearance of the solar cell may be impaired. The inventor of the present invention has also found that this cloudiness of the antireflective film occurs relatively noticeably when diphosphorus pentoxide is mixed as the n-type dopant material with the antireflective-film-forming solution.

As a result of earnest study, the inventor of the present invention has found that the cause of the cloudiness of the antireflective film lies in hygroscopicity of the metal oxide and/or the precursor of the metal oxide. Specifically, the general metal oxide and precursor of the metal oxide used in the antireflective-film-forming solution have high hygroscopicity, and when application is performed in the humid atmosphere, the metal oxide and the precursor of the metal oxide react with water in the atmosphere, which results in cloudiness of the antireflective film. Since diphosphorus pentoxide is also highly hygroscopic, diphosphorus pentoxide contributes to this cloudiness.

As a result of further earnest study, the inventor of the present invention has found that by applying antireflective-film-forming solution 5a in such an atmosphere that a water content is 0 g/m³ or more and 9.4 g/m³ or less as described above, the cloudiness of the antireflective film formed from antireflective-film-forming solution 5a can be reduced and the solar cell having excellent appearance can be manufactured in a stable manner. The present invention has been thus completed.

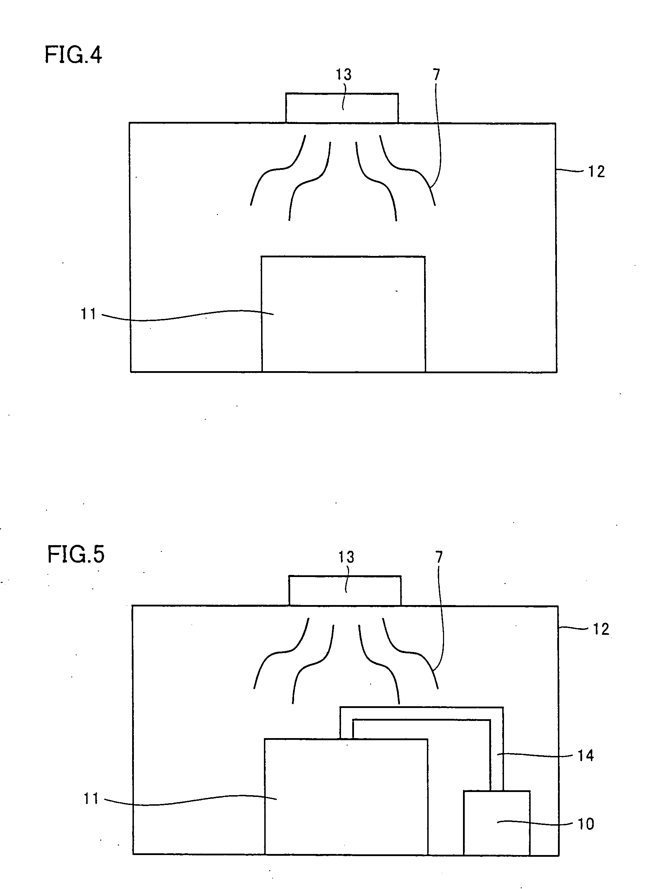

Fig. 4 shows a schematic view illustrating another example of the step of applying antireflective-film-forming solution 5a. The example shown in Fig. 4 is characterized in that application apparatus 11 is placed within a drying chamber 12, and the step of applying antireflective-film-forming solution 5a is performed in application apparatus 11 while introducing a dry gas 7 from a dry gas introduction portion 13 into the atmosphere in drying chamber 12. In this example, by dry gas 7 introduced from dry gas introduction portion 13 into the atmosphere in drying chamber 12, antireflective-film-forming solution 5a can be applied in such an atmosphere that a water content is 0 g/m³ or more and 9.4 g/m³ or less.

Fig. 5 shows a schematic view illustrating another example of the step of applying antireflective-film-forming solution 5a. The example shown in Fig. 5 is characterized in that dry gas supply apparatus 10 shown in Fig. 3 and dry gas introduction portion 13 shown in Fig. 4 are used together. In this example, by the dry gas introduced from dry gas supply apparatus 10 through dry gas introduction pipe 14 to application apparatus 11 and dry gas 7 introduced from dry gas introduction portion 13 into the atmosphere in drying chamber 12, antireflective-film-forming solution 5a can be applied in such an atmosphere that a water content is 0 g/m³ or more and 9.4 g/m³ or less.

A gas whose water content is 0 g or more and 9.4 g or less per 1 m³ of the dry gas can, for example, be used as the dry gas. In addition, a gas containing at least one type selected from the group consisting of oxygen, nitrogen, helium, neon, argon, krypton, xenon, and radon can be preferably used as the dry gas. In this case, reaction between antireflective-film-forming solution 5a and the dry gas can be reduced. Therefore, there is a tendency that cloudiness of the antireflective film can be reduced more effectively and the solar cell having excellent appearance can be manufactured in a stable manner.

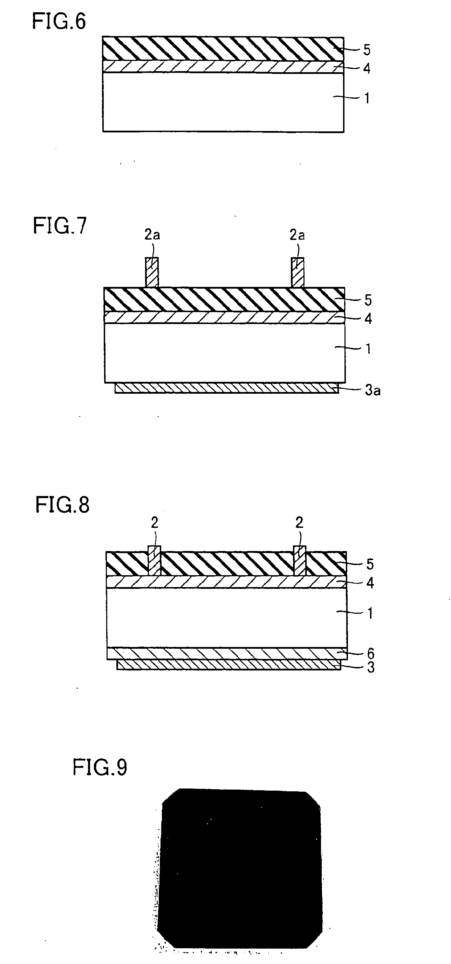

As described above, antireflective-film-forming solution 5a is applied onto the first main surface of p-type silicon substrate 1, and then, p-type silicon substrate 1 having antireflective-film-forming solution 5a applied thereon is heated. As a result, when antireflective-film-forming solution 5a contains the n-type dopant, antireflective-film-forming solution 5a is heated and an antireflective film 5 is formed on the first main surface of p-type silicon substrate 1 as shown in a schematic cross-sectional view in Fig. 6, for example. In addition, the n-type dopant is diffused from antireflective-film-forming solution 5a onto the surface of p-type silicon substrate 1, and thereby, an n-type dopant diffusion layer 4 is formed on the first main surface of p-type silicon substrate 1. At this time, p-type silicon substrate 1 having antireflective-film-forming solution 5a applied thereon is heated at a temperature of, for example, 800 to 950°C for, for example, 5 to 30 minutes.

Next, as shown in a schematic cross-sectional view in Fig. 7, a silver paste 2a containing silver powders, glass frit, a resin, and an organic solvent is, for example, printed on a surface of antireflective film 5 on the first main surface of p-type silicon substrate 1 by screen printing and the like. In addition, an aluminum paste 3a containing aluminum powders, glass frit, a resin, and an organic solvent is, for example, printed by screen printing and the like on a second main surface that is a surface opposite to the first main surface of p-type silicon substrate 1. Thereafter, a silver paste (not shown) is printed on aluminum paste 3a.

Thereafter, p-type silicon substrate 1 having the aforementioned silver pastes and aluminum paste applied thereon is heated. As a result, as shown in a schematic cross-sectional view in Fig. 8, silver paste 2a on the surface of antireflective film 5 on the first main surface of p-type silicon substrate 1 fires through antireflective film 5, and a silver electrode 2 electrically connected to n-type dopant diffusion layer 4 on the first main surface of p-type silicon substrate 1 is formed. In addition, aluminum is diffused from aluminum paste 3a and a p-type dopant diffusion layer 6 is formed on the second main surface of p-type silicon substrate 1, and an aluminum electrode 3 electrically connected to p-type dopant diffusion layer 6 is formed. Furthermore, the silver paste on aluminum paste 3a is fired, and thereby, a silver electrode (not shown) is formed on aluminum electrode 3.

In the solar cell shown in Fig. 8 fabricated as described above, n-type dopant diffusion layer 4 is formed on the first main surface of p-type silicon substrate 1, and thereby, a pn junction is formed by p-type silicon substrate 1 and n-type dopant diffusion layer 4, and antireflective film 5 and silver electrode 2 are formed on the first main surface of p-type silicon substrate 1. In addition, p-type dopant diffusion layer 6 is formed on the second main surface of p-type silicon substrate 1, and aluminum electrode 3 is formed on p-type dopant diffusion layer 6, and the silver electrode (not shown) is formed on aluminum electrode 3.

In the present embodiment, antireflective-film-forming solution 5a, which serves as a precursor of antireflective film 5, is applied onto the first main surface of p-type silicon substrate 1 in such an atmosphere that a water content is 0 g/m³ or more and 9.4 g/m³ or less as described above. Therefore, in the solar cell shown in Fig. 8, occurrence of cloudiness of antireflective film 5 can be reduced and the solar cell having excellent appearance can be manufactured in a stable manner even in mass production.

A plurality of the solar cells shown in Fig. 8 fabricated as described above can also be connected serially to form a solar cell string, and then, the solar cell string can be sealed with a sealant to form a solar cell module.

### Example

### <Example 1>

A p-type polycrystalline silicon substrate having two square-shaped main surfaces measuring 156 mm per side and having a thickness of 200 µm was first fabricated. The p-type polycrystalline silicon substrate was fabricated by slicing a p-type polycrystalline silicon ingot by the wire saw, and then, etching the sliced p-type polycrystalline silicon ingot with an alkaline solution to remove a damaged layer on a surface thereof.

Next, an isopropyl alcohol solution containing 5 percent by mass of titanium tetraisopropoxide and 3 percent by mass of diphosphorus pentoxide was applied onto one main surface of the p-type polycrystalline silicon substrate as an antireflective-film-forming solution. The spin application apparatus was used as an apparatus for applying the antireflective-film-forming solution. Then, by introducing a dry gas into the spin application apparatus, the atmosphere in the spin application apparatus was set to such an atmosphere that a water content was 9.4 g/m³ and a temperature was 25°C, and the antireflective-film-forming solution having the aforementioned composition was spin-applied onto the main surface of the p-type polycrystalline silicon substrate in this atmosphere. Measurement of the water content in the atmosphere in the spin application apparatus was conducted by measuring relative humidity (%) at 25°C in the atmosphere by means of a humidity measuring device (THERMO/HYGROMETER MODEL SK-140TRH) manufactured by Sato Keiryoki Mfg. Co., Ltd., and calculating the water content in the atmosphere based on a product of 23.0 (g/m³) that is the amount of saturated vapor at 25°C and the relative humidity (%).

Fig. 9 shows a photograph of an appearance of the main surface of the p-type polycrystalline silicon substrate immediately after the aforementioned spin application. As shown in Fig. 9, when the antireflective-film-forming solution was spin-applied in such an atmosphere that a water content was 9.4 g/m³, the antireflective-film-forming solution was not clouded.

Next, the p-type polycrystalline silicon substrate having the antireflective-film-forming solution applied thereon was heated at 900°C for 30 minutes, and thereby, an antireflective film formed of a titanium oxide film was formed on the main surface of the p-type polycrystalline silicon substrate. In addition, phosphorus was diffused onto the main surface of the p-type polycrystalline silicon substrate, and thereby, an n-type dopant diffusion layer was formed. Then, a state of the antireflective film was visually checked. The result was that the antireflective film was not clouded.

Next, a commercially available silver paste was printed on a surface of the antireflective film on the main surface of the p-type polycrystalline silicon substrate, and a commercially available aluminum paste was printed on almost the entire main surface opposite to the side of the p-type polycrystalline silicon substrate where the antireflective film was formed. Furthermore, a silver paste was printed on a part of a surface of the aluminum paste. Then, the silver pastes and the aluminum paste were dried in the temperature atmosphere of approximately 150°C.

Thereafter, the silver paste applied onto one main surface of the p-type polycrystalline silicon substrate as well as the aluminum paste and the silver paste applied onto the other main surface of the p-type polycrystalline silicon substrate were fired in air at a temperature of 860°C.

As a result, on one main surface of the p-type polycrystalline silicon substrate, the silver paste fired through the antireflective film, and a silver electrode that was the fired silver paste electrically connected to the n-type dopant diffusion layer was formed. On the other main surface of the p-type polycrystalline silicon substrate, aluminum was diffused from the aluminum paste, and thereby, a p-type dopant diffusion layer was formed, and an aluminum electrode that was the fired aluminum paste and a silver electrode that was the fired silver paste were formed. A solar cell in Example 1 was thus fabricated.

In Example 1, the antireflective film was not clouded and the solar cell having excellent appearance was able to be manufactured. Therefore, in accordance with the manufacturing method in Example 1, cloudiness of the antireflective film can be reduced and the solar cell having excellent appearance can be manufactured in a stable manner.

### <Example 2>

An antireflective-film-forming solution was spin-applied onto one main surface of a p-type polycrystalline silicon substrate similarly to Example 1 except that a water content in the atmosphere was 6.7 g/m³.

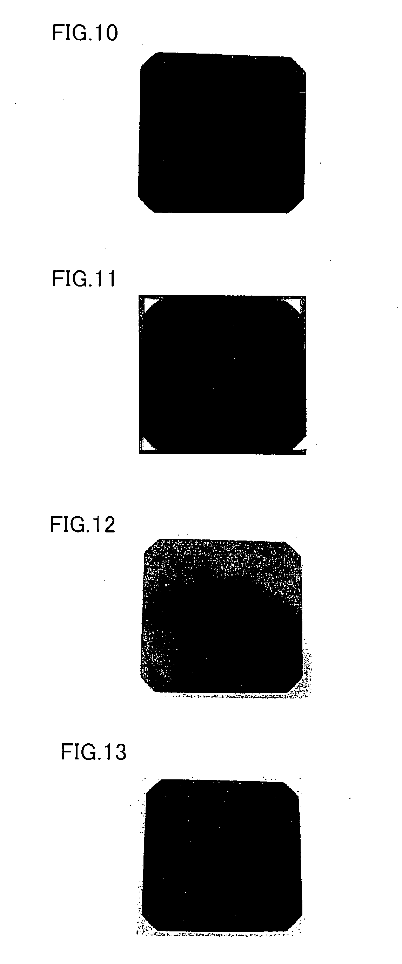

Fig. 10 shows a photograph of an appearance of the main surface of the p-type polycrystalline silicon substrate immediately after the aforementioned spin application. As shown in Fig. 10, even when the antireflective-film-forming solution was spin-applied in such an atmosphere that a water content was 6.7 g/m³ and a temperature was 25°C, the antireflective-film-forming solution was not clouded.

Next, similarly to Example 1, the p-type polycrystalline silicon substrate having the antireflective-film-forming solution applied thereon was heated, and thereby, an antireflective film formed of a titanium oxide film was formed on the main surface of the p-type polycrystalline silicon substrate. In addition, an n-type dopant diffusion layer was formed on the main surface of the p-type polycrystalline silicon substrate. Then, a state of the antireflective film was visually checked. The result was that the antireflective film was not clouded.

Thereafter, a solar cell in Example 2 was fabricated similarly to Example 1. In the solar cell in Example 2 as well, the antireflective film was not clouded and the solar cell having excellent appearance was able to be manufactured. Therefore, in accordance with the manufacturing method in Example 2 as well, cloudiness of the antireflective film can be reduced and the solar cell having excellent appearance can be manufactured in a stable manner.

### <Example 3>

An antireflective-film-forming solution was spin-applied onto one main surface of a p-type polycrystalline silicon substrate similarly to Example 1 except that a water content in the atmosphere was 6.4 g/m³.

Fig. 11 shows a photograph of an appearance of the main surface of the p-type polycrystalline silicon substrate immediately after the aforementioned spin application. As shown in Fig. 11, even when the antireflective-film-forming solution was spin-applied in such an atmosphere that a water content was 6.4 g/m³ and a temperature was 25°C, the antireflective-film-forming solution was not clouded.

Next, similarly to Example 1, the p-type polycrystalline silicon substrate having the antireflective-film-forming solution applied thereon was heated, and thereby, an antireflective film formed of a titanium oxide film was formed on the main surface of the p-type polycrystalline silicon substrate. In addition, an n-type dopant diffusion layer was formed on the main surface of the p-type polycrystalline silicon substrate. Then, a state of the antireflective film was visually checked. The result was that the antireflective film was not clouded.

Thereafter, a solar cell in Example 3 was fabricated similarly to Example 1. In the solar cell in Example 3 as well, the antireflective film was not clouded and the solar cell having excellent appearance was able to be manufactured. Therefore, in accordance with the manufacturing method in Example 3 as well, cloudiness of the antireflective film can be reduced and the solar cell having excellent appearance can be manufactured in a stable manner.

### <Example 4>

Instead of the p-type polycrystalline silicon substrate used in Examples 1 to 3, an n-type monocrystalline silicon substrate having two substantially-square-shaped main surfaces measuring 156 mm per side and having a thickness of 120 µm was fabricated. The n-type monocrystalline silicon substrate was fabricated by slicing an n-type monocrystalline silicon ingot by the wire saw, and then, etching the sliced n-type monocrystalline silicon ingot with an alkaline solution to remove a damaged layer on a surface thereof.

Next, a diffusion mask was formed on a part of one main surface of the n-type monocrystalline silicon substrate by an inkjet printing method, and then, an n-type dopant diffusion layer was formed on a portion of the main surface of the n-type monocrystalline silicon substrate that was not covered with the diffusion mask. Thereafter, the diffusion mask was removed.

Next, a diffusion mask was formed by the inkjet printing method on the other part of the main surface of the n-type monocrystalline silicon substrate on the side where the n-type dopant diffusion layer was formed, and then, a p-type dopant diffusion layer was formed on a portion of the main surface of the n-type monocrystalline silicon substrate that was not covered with the diffusion mask. Thereafter, the diffusion mask was removed.

As described above, the n-type dopant diffusion layer was formed on the part of the main surface of the n-type monocrystalline silicon substrate, and the p-type dopant diffusion layer was formed on the portion of the main surface of the n-type monocrystalline silicon substrate that was different from the n-type dopant diffusion layer.

Next, similarly to Examples 1 to 3, an antireflective-film-forming solution was spin-applied onto the main surface of the n-type monocrystalline silicon substrate opposite to the side where the n-type dopant diffusion layer and the p-type dopant diffusion layer were formed. The atmosphere in the spin application apparatus during spin application of the antireflective-film-forming solution was set to such an atmosphere that a water content was 9.4 g/m³ and a temperature was 25°C. The surface of the n-type monocrystalline silicon substrate immediately after spin application was visually checked. The result was that the antireflective-film-forming solution was not clouded.

Next, the n-type monocrystalline silicon substrate having the antireflective-film-forming solution applied thereon was heated at 900°C for 30 minutes, and thereby, an antireflective film formed of a titanium oxide film was formed on the main surface of the n-type monocrystalline silicon substrate. In addition, phosphorus was diffused onto the main surface of the n-type monocrystalline silicon substrate, and thereby, an n-type dopant diffusion layer was formed. Then, a state of the antireflective film was visually checked. The result was that the antireflective film was not clouded.

Next, the n-type monocrystalline silicon substrate was heated in the atmosphere including oxygen, and thereby, a silicon oxide film was formed on the main surface of the n-type monocrystalline silicon substrate on the side where the n-type dopant diffusion layer and the p-type dopant diffusion layer were formed.

Next, an etching mask was formed by the inkjet printing method on a part of the silicon oxide film formed on one main surface of the n-type monocrystalline silicon substrate, and a portion of the silicon oxide film that was not covered with the etching mask was removed by etching to expose the n-type dopant diffusion layer and the p-type dopant diffusion layer. Thereafter, the etching mask was removed. An area of the region of the silicon oxide film removed by etching was smaller than an area of the respective regions of the n-type dopant diffusion layer and the p-type dopant diffusion layer.

Next, a silver paste was printed on the respective exposed regions of the n-type dopant diffusion layer and the p-type dopant diffusion layer by the screen printing method, and the silver paste was dried in the atmosphere of about 150°C. An area of the region where the silver paste was printed was larger than the area of the region of the removed silicon oxide film and smaller than the area of the respective regions of the n-type dopant diffusion layer and the p-type dopant diffusion layer. In other words, the silver paste was printed on the respective regions of the n-type dopant diffusion layer and the p-type dopant diffusion layer to cover a part of the silicon oxide film.

Thereafter, the silver paste printed on one main surface of the n-type monocrystalline silicon substrate was fired in air at a temperature of 860°C, and thereby, a silver electrode was formed.

As described above, a solar cell in Example 4 was fabricated. The antireflective film was formed on one main surface of the n-type monocrystalline silicon substrate of the solar cell in Example 4, and the n-type dopant diffusion layer was formed directly beneath the antireflective film. In addition, the silicon oxide film and the silver electrode were formed on the other main surface of the n-type monocrystalline silicon substrate of the solar cell in Example 4, and the n-type dopant diffusion layer and the p-type dopant diffusion layer were formed directly beneath the silicon oxide film and the silver electrode.

In Example 4, the antireflective film was not clouded and the solar cell having excellent appearance was able to be manufactured. Therefore, in accordance with the manufacturing method in Example 4, cloudiness of the antireflective film can be reduced and the solar cell having excellent appearance can be manufactured in a stable manner.

Even when the solar cell was fabricated similarly to Example 4 except that a water content in the atmosphere in the spin application apparatus during spin application of the antireflective-film-forming solution was 6.7 g/m³, the antireflective film was not clouded.

Furthermore, even when the solar cell was fabricated similarly to Example 4 except that a water content in the atmosphere in the spin application apparatus during spin application of the antireflective-film-forming solution was 6.4 g/m³, the antireflective film was not clouded.

### <Comparative Example 1>

An antireflective-film-forming solution was spin-applied onto one main surface of a p-type polycrystalline silicon substrate similarly to Example 1 except that a water content in the atmosphere was 11.2 g/m³.

Fig. 12 shows a photograph of an appearance of the main surface of the p-type polycrystalline silicon substrate immediately after the aforementioned spin application. As shown in Fig. 12, when the antireflective-film-forming solution was spin-applied in such an atmosphere that a water content was 11.2 g/m³ and a temperature was 25°C, the antireflective-film-forming solution was clouded.

Next, similarly to Example 1, the p-type polycrystalline silicon substrate having the antireflective-film-forming solution applied thereon was heated, and thereby, an antireflective film formed of a titanium oxide film was formed on the main surface of the p-type polycrystalline silicon substrate. In addition, an n-type dopant diffusion layer was formed on the main surface of the p-type polycrystalline silicon substrate. Then, a state of the antireflective film was visually checked. The result was that the antireflective film was still clouded.

Thereafter, a solar cell in Comparative Example 1 was fabricated similarly to Example 1. In the solar cell in Comparative Example 1, the antireflective film was clouded and the solar cell having impaired appearance was manufactured. Therefore, in accordance with the manufacturing method in Comparative Example 1, cloudiness of the antireflective film cannot be reduced and the solar cell having excellent appearance cannot be manufactured in a stable manner.

### <Comparative Example 2>

An antireflective-film-forming solution was spin-applied onto one main surface of a p-type polycrystalline silicon substrate similarly to Example 1 except that a water content in the atmosphere was 9.7 g/m³.

Fig. 13 shows a photograph of an appearance of the main surface of the p-type polycrystalline silicon substrate immediately after the aforementioned spin application. As shown in Fig. 13, when the antireflective-film-forming solution was spin-applied in such an atmosphere that a water content was 9.7 g/m³ and a temperature was 25°C, the antireflective-film-forming solution was clouded.

Next, similarly to Example 1, the p-type polycrystalline silicon substrate having the antireflective-film-forming solution applied thereon was heated, and thereby, an antireflective film formed of a titanium oxide film was formed on the main surface of the p-type polycrystalline silicon substrate. In addition, an n-type dopant diffusion layer was formed on the main surface of the p-type polycrystalline silicon substrate. Then, a state of the antireflective film was visually checked. The result was that the antireflective film was still clouded.

Thereafter, a solar cell in Comparative Example 2 was fabricated similarly to Example 1. In the solar cell in Comparative Example 2, the antireflective film was clouded and the solar cell having impaired appearance was manufactured. Therefore, in accordance with the manufacturing method in Comparative Example 2, cloudiness of the antireflective film cannot be reduced and the solar cell having excellent appearance cannot be manufactured in a stable manner.

### <Summary>

The aforementioned results of Examples 1 to 3 and Comparative Examples 1 and 2 will be examined. When the antireflective-film-forming solution was applied onto one main surface of the p-type polycrystalline silicon substrate in such an atmosphere that a water content was 9.4 g/m³ or less, cloudiness of the antireflective film was able to be reduced and the solar cell having excellent appearance was able to be manufactured in a stable manner. This tendency did not change even when the water content decreased. Therefore, by applying the antireflective-film-forming solution in such an atmosphere that a water content is 0 g/m³ or more and 9.4 g/m³ or less, cloudiness of the antireflective film could be reduced and the solar cell having excellent appearance could be manufactured in a stable manner.

It should be understood that the embodiments and examples disclosed herein are illustrative and not limitative in any respect. The scope of the present invention is defined by the terms of the claims, rather than the description above, and is intended to include any modifications within the scope and meaning equivalent to the terms of the claims.

### INDUSTRIAL APPLICABILITY

The present invention can be suitably used in a method for manufacturing a solar cell.

### REFERENCE SIGNS LIST

1 p-type silicon substrate; 2 silver electrode; 2a silver paste; 3 aluminum electrode; 3a aluminum paste; 4 n-type dopant diffusion layer; 5 antireflective film; 5a antireflective-film-forming solution; 6 p-type dopant diffusion layer; 7 dry gas; 8 rotating plate; 9 application nozzle; 10 dry gas supply apparatus; 11 application apparatus; 12 drying chamber; 13 dry gas introduction portion; 14 dry gas introduction pipe

## Claims

1. A method for manufacturing a solar cell, comprising the steps of:
applying an antireflective-film-forming solution (5a) containing at least one of a metal oxide and a precursor of the metal oxide onto one main surface of a semiconductor substrate (1); and
heating said semiconductor substrate (1) having said antireflective-film-forming solution (5a) applied thereon, wherein
in said step of applying an antireflective-film-forming solution (5a), said antireflective-film-forming solution (5a) is applied in such an atmosphere that a water content is 0 g/m³ or more and 9.4 g/m³ or less.

2. The method for manufacturing a solar cell according to claim 1, wherein
said antireflective-film-forming solution (5a) contains a dopant for forming a pn junction on said semiconductor substrate (1).

3. The method for manufacturing a solar cell according to claim 1 or 2, wherein
said antireflective-film-forming solution (5a) contains a dopant for forming an n-type dopant diffusion layer (4) on said semiconductor substrate (1).

4. The method for manufacturing a solar cell according to any one of claims 1 to 3, wherein
in said step of applying an antireflective-film-forming solution (5a), said antireflective-film-forming solution (5a) is applied in such an atmosphere that said atmosphere includes a dry gas (7).

5. The method for manufacturing a solar cell according to any one of claims 1 to 4, wherein
in said step of applying an antireflective-film-forming solution (5a), said antireflective-film-forming solution (5a) is applied while introducing a dry gas (7) into said atmosphere.

6. The method for manufacturing a solar cell according to claim 4 or 5, wherein
said dry gas (7) contains at least one type selected from the group consisting of oxygen, nitrogen, helium, neon, argon, krypton, xenon, and radon.

7. The method for manufacturing a solar cell according to any one of claims 1 to 6, wherein
said antireflective-film-forming solution (5a) is a solution containing titanium alkoxide.
